# EUROPÄISCHE PATENTSCHRIFT

(11) **EP 0 936 678 B1**
(45) Veröffentlichungstag und Bekanntmachung des Hinweises auf die Patenterteilung: **21.03.2007**
(21) Anmeldenummer: 98124017.9
(22) Anmeldetag: 17.12.1998
(51) Int. Cl.: H01L 29/92, H01L 21/3205, H01L 21/285

(54) **Schaltungsanordnung mit mindestens einem Kondensator und Verfahren zu deren Herstellung**
Circuit structure with at least one capacitor and corresponding method
Structure de circuit avec au moins un condensateur et son procédé de fabrication

(30) Priorität: 16.02.1998 DE 19806307
(43) Veröffentlichungstag der Anmeldung: 18.08.1999
(73) Patentinhaber: Infineon Technologies AG, 81669 München (DE)
(72) Erfinder: Willer, Josef Dr., 85521 Riemerling (DE)
(74) Vertreter: Reinhard - Skuhra - Weise & Partner

(56) Entgegenhaltungen:
- EP-A- 0 412 185
- EP-A- 0 697 720
- EP-A- 0 722 190
- DE-C- 4 300 808
- US-A- 5 566 045
- REID J S ET AL: "EVALUATION OF AMORPHOUS (MO,TA,W)-SI-N DIFFUSION BARRIERS FOR (SI)/CU METALLIZATIONS" THIN SOLID FILMS, Bd. 236, Nr. 1/02, 15. Dezember 1993, Seiten 319-324, XP000415529
- SHIMOOKA Y ET AL: "CORRELATION OF W-SI-N FILM MICROSTRUCTURE WITH BARRIER PERFORMANCE AGAINST CU DIFFUSION" JAPANESE JOURNAL OF APPLIED PHYSICS, Bd. 36, Nr. 3B, PART 01, März 1997, Seiten 1589-1592, XP000703083
- PATENT ABSTRACTS OF JAPAN vol. 096, no. 005, 31. Mai 1996 & JP 08 017822 A (NEC CORP), 19. Januar 1996

## Beschreibung

Im Hinblick auf immer schnellere Bauelemente bei höherer Integrationsdichte nehmen die Strukturgrößen integrierter Schalteranordnungen von Generation zu Generation ab. Für Kondensatoren als Bauelemente ist die Erhöhung der Packungsdichte problematisch, da eine bloße Verkleinerung seiner Abmessungen zu einer Verkleinerung der Oberflächen seiner Kondensatorelektroden und damit zu einer Verkleinerung seiner Kapazität führt.

Die DE 43 00 808 C1 beschreibt ein Verfahren zur Herstellung eines Vielschichtkondensators mit alternierend leitfähigen Schichten und dielektrischen Schichten wobei eine der leitfähigen Schichten aus Wolframsilicid (WSi₀₄) besteht.

Um dieses Problem zu lösen, wurden Kondensatordielektrika mit hohen Dielektrizitätskonstanten entwickelt, die trotz kleiner Oberfläche der Kondensatorelektroden des Kondensators eine große Kapazität bewirken können (siehe z.B. Lee et al., Integration of (Ba, Sr)TiO₃ Capacitor with Platinum Electrodes Having SiO₂ Spacer, Conference Proceedings IEDM-97, IEEE 1997 Seite 249 bis 252).

In Y. Kawamoto et al., "A 1.28 µm² Bit-Line Shielded Memory Cell Technology for 64 Mbit DRAM's", Techn. Digest of VLSI Symposium 1990, Seite 13 und 14 wird eine DRAM-Zellenanordnung mit einem Kondensator beschrieben, bei der eine Kondensatorelektrode als Kronenstruktur ausgebildet ist. Trotz kleiner Querschnittsfläche besitzt eine Kronenstruktur eine große Oberfläche. Deshalb bewirkt eine kronenförmige Kondensatorelektrode eine große Kapazität des Kondensators bei gleichzeitig hoher Packdichte. Als Material für die Kondensatorelektrode wird Polysilizium verwendet.

Für Kondensatoren, deren Kondensatordielektrika aus Barium-Strontium-Titaniat (BST) bestehen, wird als Material für Kondensatorelektroden zur Zeit hauptsächlich Platin eingesetzt (siehe z.B. Khamankar et al., A Novel BST Storage Capacitor Node Technology Using Platinum Electrodes for Gbit DRAM's, IEDM (1997) Seiten 245 bis 248). Ein gravierender Nachteil der Verwendung von Platin besteht darin, dass bisher kein geeigneter anisotroper Ätzprozess bekannt ist, mit dem die in der Halbleiterfertigung üblichen Ätzraten von bis zu 1 µm pro Minute realisiert werden können. Aufgrund des langsamen und nicht völlig anisotropen Ätzprozesses können nur relativ dünne Platinschichten strukturiert werden. Die Erzeugung einer komplizierten Kronenstruktur aus einer dicken Platinschicht zur Vergrößerung der Oberfläche der Kondensatorelektroden und damit zur Vergrößerung der Kapazität des Kondensators bei gleichzeitig hoher Packungsdichte ist derzeit nicht möglich.

Die EP-A-0 697 720 beschreibt einen Kondensator, bei dem auf einer mit Platin bedeckten Elektrode ein ferroelektrisches Material als Dielektrikum abgeschieden ist. Eine Barrierenschicht aus Titansiliziumnitrid oder Wolframnitrid wird zwischen der Platinschicht und einem Siliziumsubstrat angeordnet.

In EP-A-0 722 190 werden amorphe TaSiN- oder WSiN-Barrieren empfohlen.

In Y. Nishioka et al., Giga-bit DRAM Cell with New Simple Ru/ (BA, Sr) TiO₃/Ru Stacked Capacitors using X-ray Lithography, IEDM (1995) Seiten 903 bis 906, ist vorgeschlagen worden, Ruthenium als Material für Kondensatorelektroden zu verwenden.

Allerdings ist Ruthenium bisher in der Halbleiterfertigung nicht eingeführt und birgt deshalb die Risiken ausbeutebegrenzender Kontaminationen in sich. Ferner würde die Verwendung von Ruthenium einen erheblichen Entwicklungsaufwand für neue Fertigungsanlagen erfordern.

Aus Mark Nicolett Armophous Metallic Alloys in Semiconductor Contact Metallizations, 400 Solid State Technology 26 (1983 Dec., Nr. 12, Port Washington, New York, USA ist bekannt, zwischen einem Substrat und einer Metallisierungsebene einen dünnen Film aus einer amorphen metallischen Verbindung anzuordnen, die die Diffusion von Atomen aus der Metallisierungsebene in das Substrat verhindert. Amorphe Materialien weisen keine Kongruenzen auf, die als schnelle Diffusionspfade für Atome wirken. Es werden Regeln für die Wahl von Elementen vorgestellt, deren Kombination eine amorphe metallische Verbindung ergibt. Nach diesen Regeln ist es besonders wichtig, dass sich die Atomradien der Elemente um mindestens 10% voneinander unterscheiden.

Aus der europäischen Patentanmeldung 0 412 185 A1 ist bekannt, z.B. WSiₓ mit 0,3 < x < 0,7 als Material für eine dünne Diffusionsbarriere, die zwischen einer Metallisierungsebene und einem GaAs-Substrat angeordnet ist, zu verwenden.

In DE 43 00 808 ist Verfahren zur Herstellung eines Vielschichtkondensators beschrieben. Zur Herstellung des Kondensators wird auf ein Substrat ein Schichtaufbau aufgebracht, der alternierend leitfähige Schichten und dielektrische Schichten umfaßt, und in dem aufeinanderfolgende leitfähige Schichten jeweils aus einem von zwei unterschiedlichen Materialien gebildet werden, die gegenseitig zueinander selektiv ätzbar sind. In dem Schichtaufbau werden zwei Öffnungen erzeugt, wobei in der ersten Öffnung durch selektives Ätzen des einen Materials und in der zweiten Öffnung durch selektives Ätzen des anderen Materials Unterätzungen gebildet werden, so daß jeweils nur die leitfähigen Schichten aus dem nicht geätzten Material an in die Öffnungen eingebrachte Kontakte angrenzen. Wesentlich ist, daß das erste Material selektiv zum zweiten Material ätzbar ist. Es wird vorgeschlagen, das erste Material aus Wolfram und das zweite Material aus WSi_{0,4} zu bilden, da WSi_{0,4} ausgeprägte Ätzeigenschaften aufweist.

Der Erfindung liegt das Problem zugrunde, eine Schaltungsanordnung mit mindestens einem Kondensator anzugeben, wobei der Kondensator mit hoher Packungsdichte und mit im Vergleich zum Stand der Technik verringertem Prozeßaufwand herstellbar ist. Ferner soll ein Verfahren zu deren Herstellung angegeben werden.

Das Problem wird gelöst durch eine Schaltungsanordnung gemäß Anspruch 1 und ein Verfahren gemäß Anspruch 7. Weitere Ausgestaltungen der Erfindung gehen aus den übrigen Ansprüchen hervor.

Der Kondensator umfaßt mindestens eine erste Kondensatorelektrode, die zumindest teilweise WSiₓ mit 0,3 < x < 0,7 umfaßt. Ferner umfaßt der Kondensator ein Kondensatordielektrikum, daß ein Ferroelektrikum enthält.

Es liegt im Rahmen der Erfindung, wenn auch eine zweite Kondensatorelektrode WSiₓ mit 0,3 < x < 0,7 als Material enthält. Die zweite Kondensatorelektrode muß nicht unbedingt WSiₓ als Material enthalten. In dem Fall bezieht sich das Folgende nur auf die erste Kondensatorelektrode.

Die Verwendung von WSiₓ als Material für die Kondensatorelektroden verringert den Prozeßaufwand: Erstens ist das Element W in der Halbleiterfertigung verbreitet und stellt kein Kontaminationsrisiko dar.

Zweitens kann WSiₓ unter Einsatz der üblichen Fertigungsanlage geätzt werden, weshalb Entwicklungskosten eingespart werden.

Drittens können zur Erzeugung von Schichten aus WSiₓ gebräuchliche Sputter- oder CVD- Anlagen verwendet werden.

Die Verringerung des Prozeßaufwands gilt insbesondere, wenn die Schaltungsanordnung in Substraten erzeugt werden, die Silizium umfassen, wie z.B. monokristalline Siliziumscheiben oder SOI-Substraten.

WSiₓ ist mit hohen Ätzraten anisotrop ätzbar. Als Ätzmittel sind z.B. fluorhaltige Gase geeignet. Aufgrund der leichten Ätzbarkeit von WSiₓ können dicke Schichten strukturiert werden. Das ist vorteilhaft, da aus dicken Schichten Strukturen mit einer großen Oberfläche bei gleichzeitig großer Packungsdichte erzeugt werden können. Dient eine solche Struktur als Kondensatorelektrode, bewirkt seine große Oberfläche eine große Kapazität des Kondensators. Die Strukturen sind beispielsweise säulenförmig, würfelförmig oder kronenförmig. Sie können Vertiefungen, Vorsprünge und/oder Ausstülpungen aufweisen. Im Gegensatz zu Formen, deren Oberflächen im wesentlichen nur planar und parallel zur Oberfläche eines Substrats verlaufen, weisen die Strukturen parallel zur Oberfläche des Substrats verlaufende Querschnittsflächen auf, die deutlich kleiner als die Oberflächen der Strukturen sind. Dies ist z.B. der Fall, wenn Flanken der Struktur, d.h. im wesentlichen vertikal zur Oberfläche des Substrats verlaufende Flächen der Struktur, einen nicht vernachlässigbaren Prozentsatz der gesamten Oberfläche der Struktur ausmachen. Die Strukturen können erhaben sein, d.h. ihre Abmessung senkrecht zur Oberfläche des Substrats kann mehr als ca. 100 nm betragen.

WSiₓ mit 0,3 < x < 0,7 liegt bis 800°C in einem amorphen Zustand vor. Die Kondensatorelektroden können direkt angrenzend an das Kondensatordielektrikum angeordnet werden, ohne daß Material aus dem oder in das Kondensatordielektrikum diffundiert. Dadurch wird die Verwendung von Materialien mit hohen Dielektrizitätskonstanten, wie z.B. Ferroelektrika, für das Kondensatordielektrikum möglich, auch wenn sie leicht diffudieren. Ferroelektrika sind z.B. BST (Bariumstrontiumtitanat), SBT (Strontiumwismuttantalat), PZT (Bleizirkoniumtitanat) oder BMF (Bariummagnesiumfluorid).

Da WSiₓ mit 0,3 < x < 0,7 bis 800°C stabil bleibt, können Prozeßschritte mit hohen Temperaturen der Erzeugung der Kondensatorelektroden folgen. Dies ist beispielsweise der Fall, wenn das Kondensatordielektrikum aus BST auf der ersten oder der zweiten Kondensatorelektrode erzeugt wird. Damit das Kondensatordielektrikum im Zustand mit der hohen Dielektrizitätskonstanten stabilisiert wird, ist eine thermische Nachbehandlung mit über 400°C erforderlich.

Ein weiterer Vorteil der Verwendung von WSiₓ mit 0,3 < x < 0,7 ist, daß bei Prozeßschritten, bei denen ein Erhitzen unter Sauerstoffatmosphäre durchgeführt wird, die Aufoxidation der Kondensatorelektroden gering ist, da dieses WSiₓ chemisch abgesättigt und seine Sauerstoffaffinität gering ist. Solche Prozeßschritte sind in der Regel für die Erzeugung aller Kondensatordielektrika mit hohen Dielektrizitätskonstanten erforderlich (vgl. z.B. S. Sun und M. Tai, Effect of Bottom Electrode Materials on the Electrical and Reliability Caracteristics of (Ba, Sr)TiO₃ Capacitors).

Um den amorphen Zustand des WSiₓ mit 0,3 < x < 0,7 zu stabilisieren, ist es vorteilhaft, dieses Material zu nitridieren. Die Nitridierung ist nicht Gegenstand der in den Patentansprüchen beanspruchten Lehre. Dies kann z.B. dadurch erfolgen, daß das WSiₓ reaktiv, d.h. in einer N₂-haltigen Gaszusammensetzung gesputtert wird. Ein solcher Prozeß läuft üblicherweise bei einem Gasdruck eines Ar/N₂-Gemisches von ca. 1 bis 20 mTorr ab. Der N₂-Anteil kann zur Prozeßoptimierung im Hinblick auf den N-Gehalt des gesputterten Materials und auf seinen Streß variiert werden. Der N-Anteil kann z.B. 50% betragen. Bei Einsatz eines CVD-Verfahrens ist es möglich, dem verwendeten Gasgemisch NH₃ zuzuführen, was zum Einbau von N in das Material während des Abscheidevorgangs führt.

Eine erfindungsgemäße Schaltungsanordnung ist insbesondere eine mit einer Speicherfunktion.

Eine erfindungsgemäße Schaltungsanordnung ist insbesondere als DRAM-Zellenanordnung geeignet. In diesem Fall ist der Kondensator mit mindestens einem Transistor verbunden. Der Transistor kann ein Auswahltransistor sein, der mit Wort- und Bitleitungen verbunden ist, die dem Aus- und Einlesen von Informationen dienen. Transistoren der DRAM-Zellenanordnung können planar oder vertikal sein.

Der Kondensator kann einen Querschnitt aufweisen, der kleiner als oder gleich 4F² ist, wobei F die minimale, in der verwendeten Technologie herstellbare Strukturgröße ist.

Es liegt im Rahmen der Erfindung einen Teil der Kondensatorelektrode, der nicht an das Kondensatordielektrikum angrenzt, aus einem anderen leitenden Material, wie z.B. dotiertes Polysilizium, Titannitrid, Siliziden, Metallen, wie Wolfram, Titan, Kobalt oder Molybdän, oder Legierungen, zu erzeugen.

Im Folgenden wird ein Ausführungsbeispiel der Erfindung, das in den Figuren dargestellt ist, näher erläutert.
- Figur 1: zeigt einen Querschnitt durch ein Substrat, das Auswahltransistoren umfaßt, nachdem eine isolierende Schicht, Kontakte und eine erste leitende Schicht erzeugt wurden.
- Figur 2: zeigt den Schnitt aus Figur 1, nachdem die leitende Schicht strukturiert und ein Kondensatordielektrikum erzeugt wurde.
- Figur 3: zeigt den Querschnitt aus Figur 2, nachdem eine zweite Kondensatorelektrode erzeugt wurde.
- Figur 4: zeigt einen Querschnitt durch eine Kondensatorelektrode (P1').

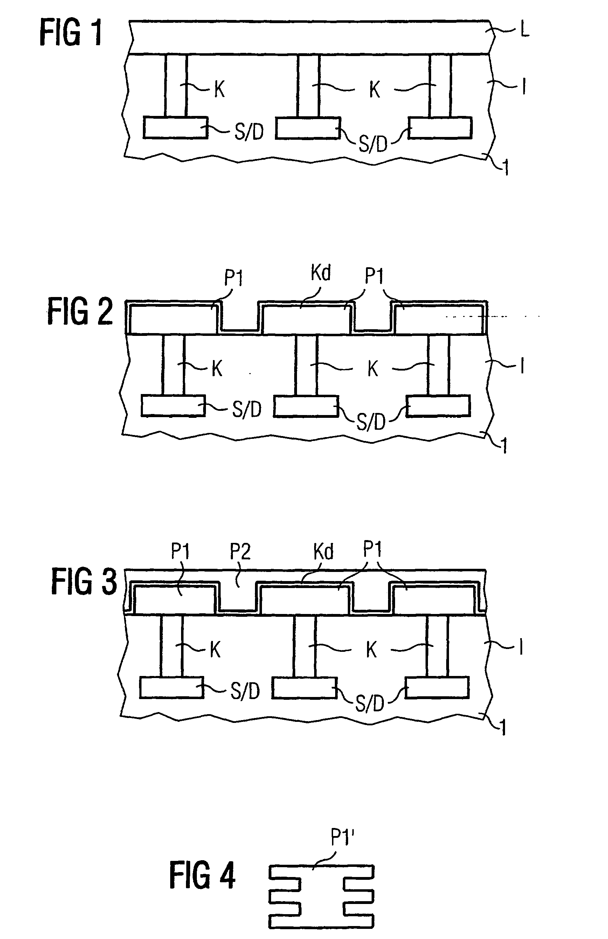

In einem Ausführungsbeispiel umfaßt ein Substrat 1, das monokristallines Silizium enthält, Auswahltransistoren einer DRAM-Zellenanordnung, deren Gateelektroden mit Wortleitungen (nicht dargestellt) verbunden sind. Auf dem Substrat 1 wird eine isolierende Schicht I abgeschieden, in der Kontakte K zu Source/Drain-Gebieten S/D der Auswahltransistoren erzeugt werden (siehe Figur 1).

Anschließend wird zur Erzeugung einer leitenden Schicht L durch Sputtern WSi_{0.4} in einer Dicke von ca. 300 nm abgeschieden (siehe Figur 1).

Mit Hilfe einer Maske (nicht dargestellt), die die Kontakte K überlappt, wird WSi_{0.4} mit z.B. CF₄ geätzt, bis die isolierende Schicht I freigelegt wird (siehe Figur 2). Aus der leitenden Schicht L entsteht dabei eine erste Kondensatorelektrode P1. Flanken der ersten Kondensatorelektrode P1 sind etwa 300 nm hoch.

Zur Erzeugung eines Kondensatordielektrikums Kd wird BST in einer Dicke von ca. 30 nm abgeschieden (siehe Figur 2).

Zur Erzeugung von zweiten Kondensatorelektroden P2 wird WSi_{0.4} in einer Dicke von 100nm abgeschieden und durch chemisch-mechanisches Polieren planarisiert. Die zweiten Kondensatorelektroden P2 bilden eine durchgehende Kondensatorplatte (siehe Figur 3).

Es sind viele Variationen des Ausführungsbeispiels denkbar, die ebenfalls im Rahmen der Erfindung liegen. Insbesondere können die Dicken der beschriebenen Schichten und Strukturen an die jeweiligen Erfordernisse angepaßt werden. Die erste Kondensatorelektrode P1' kann z.B. in Form einer Kronenstruktur erzeugt werden. Sie kann zur Vergrößerung seiner Oberfläche mit Ausstülpungen, Vorsprüngen oder Vertiefungen versehen sein (vgl. Fig. 4). Statt WSi_{0.4} kann WSiₓ mit 0.3 < x < 0.7 verwendet werden. Statt BST können andere Materialien für das Kondensatordielektrikum verwendet werden. Die zweiten Kondensatorelektroden können mit Bitleitungen verbunden werden. In diesem Fall bilden sie keine durchgehende Kondensatorplatte.

## Patentansprüche

1. Schaltungsanordnung mit mindestens einem Kondensator,
- bei der mindestens eine Kondensatorelektrode (P1) des Kondensators WSiₓ mit 0,3 < x < 0,7 enthält,
- bei der ein Kondesatordielektrikum (Kd) des Kondesators aus einem Ferroelektrikum besteht und
- das Kondensatordielektrikum an das WSiₓ der mindestens einen Kondensatorelektrode (P1) direkt angrenzt.

2. Schaltungsanordnung nach Anspruch 1,
- bei dem das Kondensatordielektrikum (Kd) BST enthält.

3. Schaltungsanordnung nach Anspruch 1 oder 2,
- bei der eine Abmessung der Kondesatorelektrode (P1) senkrecht zu einer Oberfläche eines Substrats (1), in dem die Schaltungsanordnung angeordnet ist, größer als etwa 100nm beträgt.

4. Schaltungsanordnung nach Anspruch 3,
- bei der die Kondensatorelektrode (P1') Ausstülpungen, Vorsprünge und/oder Vertiefungen aufweist.

5. Schalteranordnung nach einem der Ansprüche 1 bis 4,
- Bei der ein Substrat (1), das die Schalteranordnung umfasst, Silizium enthält.

6. Schaltungsanordnung nach einem der Ansprüche 1 bis 5,
- die eine DRAM-Zellenanordnung ist.

7. Verfahren zur Erzeugung einer Schaltungsanordnung mit mindestens einem Kondensator
- bei dem mindestens eine Kondensatorelektrode (P1) des Kondensators mindestens teilweise aus WSiₓ mit 0,3 < x < 0,7 erzeugt wird,
- bei dem ein Kondensatordielektrikum (Kd), das aus einem Ferroelektrikum besteht, des Kondensators direkt auf dem WSiₓ der Kondensatorelektrode (P1) erzeugt wird.

8. Verfahren nach Anspruch 7,
- bei dem ein Kondensatordielektrikum (Kd) aus BST erzeugt wird.

9. Verfahren nach einem der Ansprüche 7 oder 8,
- bei dem die Kondensatorelektrode (P1) durch Strukturierung einer leitenden Schicht (L), die dicker als etwa 100nm ist, erzeugt wird.

10. Verfahren nach Anspruch 9,
- bei dem die Kondensatorelektrode (P1) mit Ausstülpungen, Vorsprüngen und/oder Vertiefungen versehen wird.

11. Verfahren nach einem der Ansprüche 7 bis 10,
- bei dem die Schaltungsanordnung in einem Substrat (1) erzeugt wird, das Silizium enthält.

12. Verfahren nach einem der Ansprüche 7 bis 11,
- bei dem die Schaltungsanordnung als eine DRAM Zellenanordnung erzeugt wird.

## Claims

1. A circuit arrangement comprising at least one capacitor,
- wherein at least one capacitor electrode (P1) of the capacitor contains WSiₓ and 0,3 < x < 0,7,
- wherein a capacitor dielectric (Kd) of the capacitor is made of a ferroelectrica and
- wherein the capacitor dielectric is adjacent to the WSiₓ of the at least one capacitor electrode (P1).

2. The circuit arrangement according to claim 1,
- wherein the capacitor dielectric (Kd) contains BST.

3. The circuit arrangement according to claim 1 or 2,
- wherein a dimension of the capacitor electrode (P1) perpendicular to a surface of a substrate (1), in which the circuit arrangement is arranged, is greater than 100nm.

4. The circuit arrangement according to claim 3,
- wherein the capacitor electrode (P1') comprises protuberances, protrusions, and/or recesses.

5. The circuit arrangement according to one of the claims 1 to 4,
- wherein a substrate (1) comprising the circuit arrangement contains silicon.

6. The circuit arrangement according to one of the claims 1 to 5, which is a DRAM cell arrangement.

7. A method for manufacturing a circuit arrangement comprising at least one capacitor,
- wherein at least one capacitor electrode (P1) of the capacitor is formed at least partially of WSiₓ, wherein 0,3 < x < 0,7,
- wherein a capacitor dielectric (Kd) consisting of a ferroelectrica is formed directly on the WSiₓ of the capacitor electrode (P1).

8. The method according to claim 7, wherein a capacitor dielectric (Kd) is formed of BST.

9. The method according to one of the claims 7 or 8,
- wherein the capacitor electrode (P1) is formed by means of structuring of a conductive layer (L) which is thicker than about 100 nm.

10. The method according to claim 9,
- wherein the capacitor electrode (P1) is provided with protuberances, protrusions, and/or recesses.

11. The method according to one of the claims 7 to 10,
- wherein the circuit arrangement is formed in a substrate (1) that contains silicon.

12. The method according to one of the claims 7 to 11,
- wherein the circuit arrangement is formed as a DRAM cell arrangement.

## Revendications

1. Circuit comprenant au moins un condensateur,
dans lequel au moins une électrode de condensateur (P1) du condensateur comprend WSiₓ avec 0,3 < x < 0,7,
dans lequel un diélectrique de condensateur (Kd) du condensateur est un ferro-électrique et
le diélectrique de condensateur est directement limitrophe du WSiₓ de l'au moins une électrode de condensateur (P1).

2. Circuit selon la revendication 1 dans lequel le diélectrique de condensateur (Kd) contient du BST.

3. Circuit selon la revendication 1 ou 2 dans lequel une dimension de l'électrode de condensateur (P1) perpendiculaire à la surface d'un substrat (1), dans lequel le circuit est disposé, est plus grande que 100nm environ.

4. Circuit selon la revendication 3 dans lequel l'électrode de condensateur (P1') comprend des protubérances, des avancées et/ou des cavités.

5. Circuit selon une des revendications 1 à 4 dans lequel un substrat (1) comprenant le circuit contient du silicium.

6. Circuit selon une des revendications 1 à 5 qui est un agencement de cellules DRAM.

7. Procédé pour la réalisation d'un circuit comprenant au moins un condensateur dans lequel
- au moins une électrode de condensateur (P1) du condensateur est réalisée au moins partiellement à partir de WSiₓ avec 0,3 < x <0,7
- dans lequel un diélectrique de condensateur (Kd) du condensateur, constitué d'un ferro-électrique, est réalisé directement sur le WSiₓ de l'électrode de condensateur (P1).

8. Procédé selon la revendication 7 dans lequel un diélectrique de condensateur (Kd) est réalisé à partir de BST.

9. Procédé selon la revendication 7 ou 8 dans lequel l'électrode de condensateur (P1) est réalisée par une structuration d'une couche conductrice (L) qui est plus épaisse que 100nm environ.

10. Procédé selon la revendication 9 dans lequel l'électrode de condensateur (P1) est prévue avec des protubérances, des avancées et/ou des cavités.

11. Procédé selon une des revendications 7 à 10 dans lequel le circuit est réalisé dans un substrat (1) qui contient du silicium.

12. Procédé selon une des revendications 7 à 11 dans lequel le circuit est réalisé sous la forme d'un agencement de cellules DRAM.
